**Europäisches Patentamt**

**European Patent Office**

**Office européen des brevets**

(11) Veröffentlichungsnummer: **0 186 058**
**B1**

(12) **EUROPÄISCHE PATENTSCHRIFT**

(45) Veröffentlichungstag der Patentschrift:
28.06.89

(51) Int. Cl.⁴: **H01L 29/08,** H01L 21/265,
H01L 21/28

(21) Anmeldenummer: **85115848.5**

(22) Anmeldetag: **12.12.85**

(54) Feldeffekttransistor mit hoher Spannungsfestigkeit.

(30) Priorität: **21.12.84 DE 3446869**

(43) Veröffentlichungstag der Anmeldung:
02.07.86 Patentblatt 86/27

(45) Bekanntmachung des Hinweises auf die Patenterteilung:
28.06.89 Patentblatt 89/26

(84) Benannte Vertragsstaaten:
**DE FR GB IT NL**

(56) Entgegenhaltungen:
**US-A- 4 109 371**

**IBM TECHNICAL DISCLOSURE BULLETIN, Band 24,
Nr. 1A, Juni 1981, Seiten 55,56, New York, US; R.F.
BARTHOLOMEW et al.: "Controllable process for
fabricating an LDDFET device using preferential
etching"
IEEE JOURNAL OF SOLID-STATE CIRCUITS, Band
SC-17, Nr. 2, April 1982, Seiten 220-226, IEEE, New York,
US; P.J. TSANG et al.: "Fabrication of high-performance
LDDFET's with oxide sidewall-spacer technology"
IEEE TRANSACTIONS ON ELECTRON DEVICES, Band
ED-15, Nr. 10, Oktober 1968, Seiten 757-761, IEEE, New
York, US; R.W. BOWER et al.: "MOS field effect
transistors formed by gate masked ion implantation"**

(73) Patentinhaber: **Siemens Aktiengesellschaft Berlin und
München, Wittelsbacherplatz 2, D-8000 München 2(DE)**

(72) Erfinder: **Pfleiderer, Hans-Jörg, Dr.,
Franz-Krinninger-Weg 23, D-8011 Zorneding(DE)**

**Beschreibung**

Die Erfindung bezieht sich auf einen Feldeffekttransistor mit hoher Spannungsfestigkeit nach dem Oberbegriff des Patentanspruchs 1 sowie auf Verfahren zu dessen Herstellung.

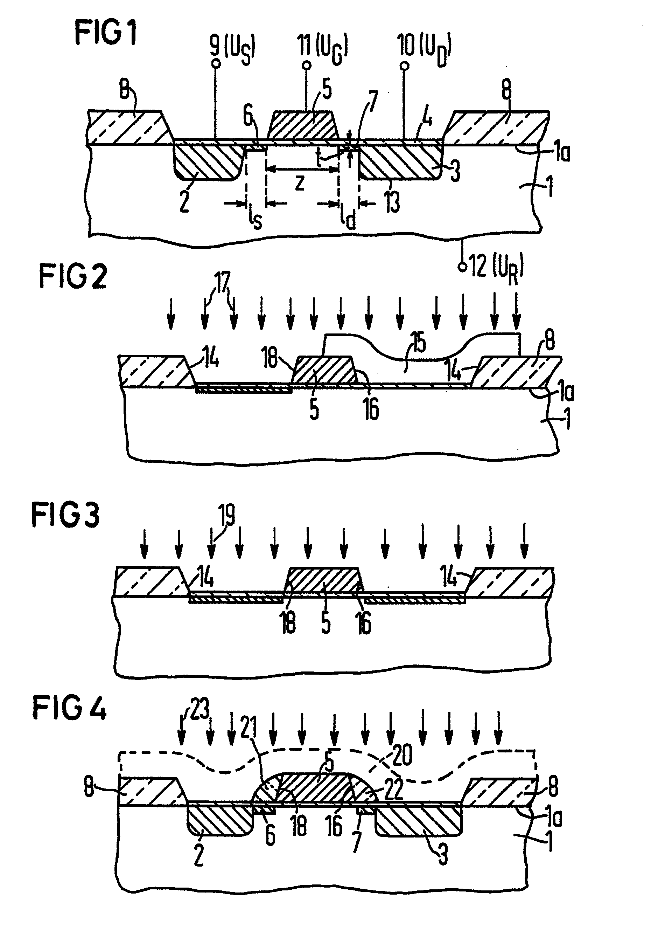

Herkömmliche Feldeffekttransistoren dieser Art sind in den IEEE Transactions on Electron Devices, Vol. ED–15, No. 10, Okt. 1968, S. 757–761, insb. Fig. 1(c) und (d) dargestellt und beschrieben. Sie haben source- und drainseitige Anschlußgebiete, deren Dotierungskonzentrationen jeweils gleich hoch sind. Daraus ergibt sich das Problem, daß je nach dem Wert dieser Dotierungskonzentration entweder eine wesentlich höhere Spannungsfestigkeit als beim Standardtransistor (ohne diese Anschlußgebiete) aber nur ein relativ flacher Anstieg der $I_D/U_{DS}$-Kennlinie im Vergleich zum Standardtransistor erreicht wird (niedriger Wert der Dotierungskonzentration) oder daß bei einem $I_D/U_{DS}$-Kennlinienverlauf normaler Steilheit, der etwa dem Standardtransistor entspricht, eine Einbuße bezüglich der durch die Anschlußgebiete an sich erreichbaren Spannungsfestigkeit hingenommen werden muß (hoher Wert der Dotierungskonzentration).

In Fig. 1(e) auf Seite 757 der genannten Literaturstelle ist ein Feldeffekttransistor dargestellt, der nur insofern vom Oberbegriff des Patentanspruchs abweicht, als das sourceseitige Anschlußgebiet durch eine Verlängerung des Sourcegebiets ersetzt ist, die dieselbe Eindringtiefe aufweist wie das Sourcegebiet und sich bis in die vom Gate überdeckte Zone des Halbleiterkörpers hinein erstreckt, so daß das Gate diese Verlängerung randseitig überdeckt. Hier werden zwar sowohl eine höhere Spannungsfestigkeit als beim Standardtransistor als auch eine höhere Steilheit der $I_D/U_{DS}$-Kennlinie im Vergleich zu einem Transistor mit niedrig dotiertem source- und drainseitigen Anschlußgebiet erreicht, doch ist ein solcher unsymmetrisch ausgelegter Transistor wegen der unterschiedlichen strukturellen Ausbildung im Source- und Drainbereich, die nur eine teilweise selbstjustierende Herstellung der umdotierten Halbleitergebiete zuläßt, schwierig und umständlich herzustellen.

Der Erfindung liegt die Aufgabe zugrunde, einen in einfacher Weise herzustellenden Feldeffekttransistor der eingangs genannten Art anzugeben, bei dem trotz einer erhöhten Spannungsfestigkeit keine wesentliche Verringerung der Steilheit der $I_D/U_{DS}$-Kennlinie in Kauf genommen werden muß. Das wird erfindungsgemäß durch eine Ausbildung desselben nach dem kennzeichnenden Teil des Patentanspruchs 1 erreicht.

Bei einem Feldeffekttransistor nach der Erfindung wird neben einer relativ großen Steilheit der $I_D/U_{DS}$-Kennlinie, die etwa der eines Standardtransistors entspricht, auch eine hohe Spannungsfestigkeit, d.h. ein hoher Wert der Durchbruchspannung erreicht, der wesentlich über dem eines Standardtransistors liegt. Als Durchbruchspannung wird hierbei diejenige Spannung $U_{DS}$ zwischen dem Drain- und dem Sourcegebiet bezeichnet, bei der ein Lawineneffekt am pn-Übergang des Draingebietes auftritt.

Der Patentanspruch 2 ist auf eine bevorzugte Ausgestaltung des Feldeffekttransistors nach der Erfindung gerichtet, während die Ansprüche 3 bis 5 vorteilhafte Verfahren zur Herstellung des erfindungsgemäßen Transistors betreffen.

Die Erfindung wird nachfolgend anhand der Zeichnung näher erläutert. Dabei zeigen:

Fig. 1 einen Feldeffekttransistor nach der Erfindung und

Fig. 2 bis Fig. 4 einzelne Verfahrensschritte bei der Herstellung eines erfindungsgemäßen Feldeffekttransistors.

In Fig. 1 ist ein Körper 1 aus dotiertem Halbleitermaterial, z.B. p-dotiertem Silizium, dargestellt, in den zwei $n^+$-dotierte Gebiete 2 und 3 so eingefügt sind, daß sie sich bis zu einer Grenzfläche 1a hin erstrecken. Sie bilden das Sourcegebiet und das Draingebiet eines Feldeffekttransistors. Die Grenzfläche 1a ist mit einer dünnen, elektrisch isolierenden Schicht 4, z.B. aus $SiO_2$, versehen. Auf dieser ist das aus elektrisch leitendem Material, z.B. hochdotiertem, polykristallinem Silizium, bestehende Gate 5 des Feldeffekttransistors angeordnet. Die Gebiete 2 und 3 erstrecken sich in lateraler Richtung nicht bis zu einer vom Gate 5 überdeckten Zone Z des Halbleiterkörpers, sondern sind durch ein sourceseitiges Anschlußgebiet 6, dessen Länge mit $l_s$ bezeichnet ist, und durch ein drainseitiges Anschlußgebiet 7, das eine Länge $l_d$ aufweist, von dem sourceseitigen Rand und dem drainseitigen Rand der Zone Z getrennt. Die Anschlußgebiete 6, 7 gehören demselben Leitfähigkeitstyp an wie die Gebiete 2 und 3, haben aber eine wesentlich geringere Eindringtiefe t und eine geringere Dotierungskonzentration als diese. Mit 8 sind Teile einer elektrisch isolierenden Schicht, z.B. aus $SiO_2$, bezeichnet, die mit einer wesentlich größeren Schichtdicke ausgeführt ist als die Schicht 4 und den aktiven Bereich des Feldeffekttransistors in lateraler Richtung begrenzt.

Im Betrieb werden den Gebieten 2 und 3 und dem Gate 5 über ihre Anschlüsse 9, 10 und 11 Spannungen $U_S$, $U_D$ und $U_G$ zugeführt, wobei der Halbleiterkörper 1 auf einem Bezugspotential $U_R$ liegt, das über einen Anschluß 12 zugeführt wird. Das drainseitige Anschlußgebiet 7 bewirkt dabei wegen seiner relativ niedrigen Dotierungskonzentration von z.B. $10^{16}$-$10^{17} cm^{-3}$, daß in der Nähe des pn-Übergangs 13 zwischen 7 und 1 nur eine relativ geringe Feldstärke auftritt, was eine relativ hohe Durchbruchspannung zur Folge hat. Das sourceseitige Anschlußgebiet 6 weist eine höhere Dotierungskonzentration auf als das Gebiet 7, jedoch eine niedrigere als das Sourcegebiet 2. Im dargestellten Ausführungsbeispiel beträgt die Dotierungskonzentration des Anschlußgebiets 6 beispielsweise $10^{18}$-$10^{19} cm^{-3}$. Das ist hinreichend hoch, um zu gewährleisten, daß die die Abhängigkeit des Drainstroms $I_D$ von der an den Anschlüssen 10 und 9 auftretenden Spannung $U_{DS}$ darstellende $I_D/U_{DS}$-Kennlinie eine

mit dem Standardtransistor (bei dem die Anschlußgebiete 6, 7 fehlen und durch entsprechende Verlängerungen der Gebiete 2 und 3 bis an die Ränder des Gate 5 ersetzt sind) vergleichbare Steilheit hat. Den widersprüchlichen Forderungen nach einer hohen Durchbruchspannung und einer hohen Steilheit der genannten Kennlinie wird also dadurch Rechnung getragen, daß Dotierungskonzentrationen der Gebiete 6 und 7 voneinander abweichen, wobei die des Gebiets 7 stets kleiner ist als die des Gebiets 6. Je größer die Abweichung der Dotierungskonzentrationen voneinander ist, desto besser wird jede der beiden genannten Forderungen erfüllt.

Anhand der Figuren 2 bis 4 wird nachfolgend ein zweckmäßiges Verfahren zur Herstellung des in Fig. 1 dargestellten Feldeffekttransistors beschrieben. Fig. 2 zeigt dabei einen Halbleiterkörper 1, der mit einer Isolierschicht 8 großer Dicke, z.B. aus $SiO_2$, versehen ist, die eine den aktiven Bereich des Feldeffekttransistors begrenzende Ausnehmung 14 aufweist. Im Bereich von 14 ist auf der Grenzfläche 1a eine dünne elektrisch isolierende Schicht, z.B. aus $SiO_2$, aufgewachsen, auf der das Gate 5 aufgebracht wird. Dies geschieht z.B. durch ein ganzflächiges Aufbringen einer Schicht aus polykristallinem Silizium, wonach eine Strukturierung des Gate 5 auf fotolithografischem Wege erfolgt. Hiervon ausgehend wird eine Maske 15, z.B. aus Fotolack, so aufgebracht, daß sie den drainseitigen Rand 16 des Gate 5 und einen an diesen angrenzenden ersten Teil des Körpers 1 abdeckt. Dieser erste Teil kann den aktiven Bereich des Feldeffekttransistors, soweit er rechts von dem drainseitigen Rand 16 des Gate 5 liegt, bis zum Rand der Ausnehmung 14 einschließen. Andererseits genügt es, wenn dieser erste Teil nur denjenigen rechts von 16 liegenden Bereich des Halbleiterkörpers 1 einschließt, der von dem drainseitigen Anschlußgebiet 7 eingenommen werden soll. Es schließt sich ein erster Dotierungsschritt an, der z.B. aus einer Ionenimplantati-on besteht, die durch Pfeile 17 angedeutet ist. Dabei wird ein Dotierstoff, der eine n-Leitung bestimmt, mit einer Dosis von z.B. $1 \times 10^{14} cm^{-2}$ in einen zweiten Teil des Halbleiterkörpers 1 eingebracht, der dem links von 18 liegenden aktiven Bereich des Feldeffekttransistors entspricht.

Anschließend wird die Dotierungsmaske 15 entfernt (Fig. 3) und ein zweiter Dotierungsschritt vorgenommen, bei dem vorzugsweise im Wege einer zweiten Ionenimplantation 19 ein Dotierstoff, der eine n-Leitung bestimmt, mit einer Dosis von beispiels-weise $5 \times 10^{12} cm^{-2}$ in den gesamten aktiven Bereich des Feldeffekttransistors außerhalb des Gate 5 eingebracht wird. Hierdurch sind die Dotierstoffe für beide Anschlußgebiete 6 und 7 im Halbleiterkörper 1 deponiert.

Gemäß Fig. 4 wird im nächsten Verfahrensschritt eine isolierende Schicht 20 isotrop über dem Gate 5 abgeschieden, welche die Teile 4, 5 und 8 abdeckt. Durch eine anisotrope Ätzung wird dann die Schicht 20 wieder so weit entfernt, daß lediglich selbstjustierende streifenförmige Seitenwandoxidteile (spacer) 21, 22 an den Rändern 18 und 16 des Gate 5 bestehen bleiben. Diese bilden zusammen mit der Isolierschicht 8 eine Dotierungsmaske für einen nachfolgenden Dotierschritt, durch den ein Dotierstoff, der eine n-Leitung bestimmt, z.B. mit einer Dosis von $5 \times 10^{15} cm^{-2}$ in den Source- und Drainbereich des Feldeffekttransistors eingebracht wird.

Nach einer Variante des vorstehend beschriebenen Verfahrens können der erste und zweite Dotierungsschritt miteinander vertauscht werden, wobei die Dotierungsmaske 15 in diesem Fall während des an die zweite Stelle gerückten, ersten Dotierungsschritts verwendet wird.

Als Dotierstoff, der die n-Leitung bestimmt, kann z.B. Phosphor oder Arsen herangezogen werden.

In Abweichung von dem bisher beschriebenen Ausführungsbeispiel kann der Feldeffekttransistor nach der Erfindung auch $p^+$-dotierte Source- und Draingebiete aufweisen, die in einen n-leitenden Halbleiterkörper eingefügt sind. In diesem Fall wird zur Herstellung der Gebiete 2, 3 und 6, 7 ein die p-Leitung bestimmender Dotierstoff, z.B. Bor verwendet.

## Patentansprüche

1. Feldeffekttransistor mit hoher Spannungsfestigkeit, bei dem ein Source- und ein Draingebiet (2, 3) eines ersten Leitfähigkeitstyps in einem Halbleiterkörper (1) eines zweiten Leitfähigkeitstyps enthalten sind, bei dem ein durch eine dünne isolierende Schicht (4) von dem Halbleiterkörper (1) getrenntes Gate (5) vorgesehen ist und bei dem ein source-und ein drainseitiges Anschlußgebiet (6, 7) vorhanden sind, die dem ersten Leitfähigkeitstyp angehören, zwischen dem Sourcegebiet (2), dem Draingebiet (3) und einer vom Gate (5) überdeckten Zone (Z) des Halbleiterkörpers liegen und eine kleinere Dotierungskonzentration sowie eine wesentlich geringere Eindringtiefe aufweisen als das Source-und das Draingebiet, dadurch gekennzeichnet, daß das drainseitige Anschlußgebiet (7) eine kleinere Dotierungskonzentration aufweist als das sourceseitige Anschlußgebiet (6).

2. Feldeffekttransistor nach Anspruch 1, dadurch gekennzeichnet, daß das Gate aus hochdotiertem polykristallinem Silizium besteht.

3. Verfahren zur Herstellung des Feldeffekttransistors nach Anspruch 1 oder 2, dadurch gekennzeichnet, daß der Halbleiterkörper (1) an ei-ner Grenzfläche (1a) mit der dünnen isolierenden Schicht (4) versehen wird, daß auf dieser das Gate (5) aufgebracht wird, daß eine Dotierungsmaske (15) vorgesehen wird, die den drainseitigen Rand (16) des Gate (5) und einen an diesen Rand in lateraler Richtung unmittelbar angrenzenden ersten Teil des Halbleiterkörpers (1) abdeckt, daß in einem unter Verwendung dieser Dotierungsmaske (15) vorgenommenen ersten Dotierungsschritt ein den er-sten Leitfähigkeitstyp bestimmender Dotierungs-stoff in einen an den sourceseitigen Rand (18) des Gate (5) angrenzenden, zweiten Teil des Halbleiterkörpers (1) eingebracht wird, daß nach dem Entfernen der Dotierungsmaske (15) in einem zweiten Dotierungsschritt ein den ersten Leitfähigkeitstyp bestimmender Dotierungsstoff in den ersten und zweiten Teil des Halbleiterkörpers (1) eingebracht wird, daß eine weitere isolierende Schicht (20) oberhalb des Gate (5) und eines an dieses angrenzenden Bereichs des Halbleiterkörpers abgeschieden wird, daß die weitere isolierende Schicht (20) bis auf zwei streifenartige Teile (21, 22), die jeweils an die sourceseitigen und drainseitigen Ränder (18, 16) des Gate angrenzen, wieder entfernt wird, daß zur Erzeugung des Source-und Draingebiets (2, 3) ein den ersten Leitfähigkeitstyp bestimmender Dotierstoff in zwei an die beiden streifenartigen Teile (21, 22) jeweils in lateraler Richtung angrenzende Gebiete (2, 3) des Halbleiterkörpers (1) eingebracht wird.

4. Verfahren nach Anspruch 3, dadurch abgewandelt, daß der erste und zweite Dotierungsschritt miteinander vertauscht werden und daß die Dotierungsmaske (15) nach dem zweiten Dotierungsschritt vorgesehen und nach dem sich anschließenden ersten Dotierungsschritt wieder entfernt wird.

5. Verfahren nach einem der Ansprüche 3 oder 4, dadurch gekennzeichnet, daß der erste Dotierungsschritt aus einer ersten Ionenimplantation besteht, die mit einer Dosis von etwa $1 \times 10^{14} \mathrm{cm}^{-2}$ durchgeführt wird und daß der zweite Dotierungsschritt aus einer zweiten Ionenimplantation besteht, die mit einer Dosis von etwa $5 \times 10^{12} \mathrm{cm}^{-2}$ erfolgt.

**Claims**

1. Field effect transistor with high breakdown voltage in which a source region and a drain region (2, 3) of a first conductivity type are incorporated in a semiconductor body (1) of a second conductivity type, in which a gate (5) separated from the semiconductor body (1) by a thin insulating layer (4) is provided, and in which a source-side connection region (6) and a drain-side connection region (7) are present which belong to the first conductivity type, are situated between the source region (2), the drain region (3) and a zone (Z) of the semiconductor body covered by the gate (5) and have a lower doping concentration and also a substantially lower penetration depth than the source region and the drain region, characterized in that the drain-side connection region (7) has a lower doping concentration than the source-side connection region (6).

2. Field effect transistor according to claim 1, characterized in that the gate is composed of highly doped polycrystalline silicon.

3. Method for manufacturing the field effect transistor according to claim 1 or 2, characterized in that the semiconductor body (1) is provided at a boundary surface (1a) with the thin insulating layer (4), in that the gate (5) is deposited thereon, in that a doping mask (15) is provided which masks the drain-side edge (16) of the gate (5) and a first part of the semiconductor body (1) immediately adjacent to said edge in the lateral direction, in that, in a first doping step undertaken using said doping mask (15), a dopant which determines the first conductivity type is introduced into a second part of the semiconductor body (1) adjacent to the source-side edge (18) of the gate (5), in that, after removing the doping mask (15), a dopant which determines the first conductivity type is introduced in a second doping step into the first and second part of the semiconductor body (1), in that a further insulating layer (20) is deposited on top of the gate (5) and a region of the semiconductor body adjacent to the latter, in that the further insulating layer (20) is removed again except for two strip-like parts (21, 22) which are each adjacent to the source-side and drain-side edges (18, 16) of the gate, in that, to produce the source region (2) and the drain region (3), a dopant which determines the first conductivity type is introduced into two regions (2, 3) of the semiconductor body (1) which are each adjacent to the two strip-like parts (21, 22) in the lateral direction.

4. Method according to claim 3, modified in that the first doping step and the second doping step are interchanged with each other and in that the doping mask (15) is provided after the second doping step and is removed again after the subsequent first doping step.

5. Method according to one of the claims 3 or 4, characterized in that the first doping step comprises a first ion implantation which is carried out with a dose of about $1 \times 10^{14}$ cm$^{-2}$ and in that the second doping step comprises a second ion implantation which is carried out with a dose of about $5 \times 10^{12}$ cm$^{-2}$

**Revendications**

1. Transistor à effet de champ présentant une rigidité diélectrique élevée et dans lequel des régions de source et de drain (2, 3) possédant un premier type de conductivité sont ménagées dans un corps semiconducteur (1) possédant un second type de conductivité, et dans lequel il est prévu une grille (5) séparée du corps semiconducteur (1) par une couche isolante mince (4) et dans lequel il est prévu des régions de raccordement (6, 7), qui sont situées du côté du drain, possèdent le premier type de conductivité, sont situées entre la région de source (2), la région de drain (3) et une zone (Z) du corps semiconducteur, recouverte par la grille (5), et possèdent une concentration de dopage inférieure ainsi qu'une profondeur de pénétration nettement inférieure à celles des régions de source et de drain, caractérisé par le fait que la région de raccordement (7), située du côté du drain, possède une concentration de dopage inférieure à celle de la région de raccordement (6), située du côté de la source.

2. Transistor à effet de champ suivant la revendication 1, caractérisé par le fait que la grille est réalisée en silicium polycristallin fortement dopé.

3. Procédé pour fabriquer le transistor à effet de champ suivant la revendication 1 ou 2, caractérisé par le fait qu'on applique au corps semiconducteur (1) une mince couche isolante (4) au niveau d'une interface (1a), qu'on dépose la grille (5) sur cette couche, qu'on prévoit un masque de dopage (15) qui revouvre le bord (16), situé du côté du drain, de la grille (5) et une première partie, qui jouxte directement ce bord dans la direction latérale, du corps semiconducteur (1), qu'au cours d'une première étape de dopage exécutée moyennant l'utilisation de ce masque de dopage (15), on insère une substance dopante, qui détermine le premier type de conducti- côté de la source, et qu'après élimination du masque de dopage (15), on introduit, lors d'une seconde étape de dopage, une substance dopante, qui détermine le premier type de conductivité, dans les première et seconde parties du corps semiconducteur (1), qu'on dépose une autre couche isolante (20) au-dessus de la grille (5) et d'une zone, jouxtant cette grille, du corps semiconducteur, qu'on élimine à nouveau l'autre couche isolante (20) hormis au niveau de deux parties en forme de bandes (21, 22), qui jouxtent respectivement les bords (18, 16) de la grille, situés du côté de la source et du côté du drain, et que, pour l'obtention des régions de source et de drain (2, 3), on dépose une substance dopante, qui détermine le premier type de conductivité, dans deux régions (2, 3) du corps semiconducteur (1), qui jouxtent les deux parties en forme de bandes (21, 22), respectivement dans la direction latérale.

4. Procédé suivant la revendication 3, caractérisé par le fait qu'on permute entre elles les première et seconde étapes de dopage et que l'on prévoit le masque de dopage (15) après la seconde étape de dopage et qu'on l'élimine, à nouveau, après la première étape de dopage ultérieure.

5. Procédé suivant l'une des revendications 3 ou 4, caractérisé par le fait que la première étape de dopage consiste en une première implantation ionique, qui est exécutée avec une dose égale à environ $1 \times 10^{14}$ cm$^{-2}$, et que la seconde étape de dopage consiste en une seconde implantation ionique, qui est exécutée avec une dose égale à environ $5 \times 10^{12}$ cm$^{-2}$.

FIG 1

FIG 2

FIG 3

FIG 4